(19) Europäisches Patentamt
European Patent Office
Office européen des brevets

(11) EP 2 533 609 A1

(12) **EUROPEAN PATENT APPLICATION**
published in accordance with Art. 153(4) EPC

(43) Date of publication:
**12.12.2012 Bulletin 2012/50**

(21) Application number: **11739857.8**

(22) Date of filing: **04.02.2011**

(51) Int Cl.:
***H05B 33/10*** *(2006.01)* ***H01L 51/50*** *(2006.01)*

(86) International application number:
**PCT/JP2011/052343**

(87) International publication number:
**WO 2011/096509 (11.08.2011 Gazette 2011/32)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **05.02.2010 JP 2010024479**

(71) Applicants:
- **Sumitomo Chemical Company, Limited**
  **Tokyo 104-8260 (JP)**
- **Panasonic Corporation**
  **Kadoma-shi**
  **Osaka 571-8501 (JP)**

(72) Inventors:
- **KAKIMOTO, Hidenobu**
  **Tsukuba-shi**
  **Ibaraki 305-0821 (JP)**
- **KUSUKAME, Haruka**
  **1-61, Shiromi 2-chome, Chuo-ku**
  **Osaka 540-6207 (JP)**
- **MATSUSUE, Noriyuki**
  **1-61, Shiromi 2-chome, Chuo-ku**
  **Osaka 540-6207 (JP)**

(74) Representative: **Jackson, Martin Peter**
**J A Kemp**
**14 South Square**
**Gray's Inn**
**London WC1R 5JJ (GB)**

# (54) ORGANIC ELECTROLUMINESCENT ELEMENT, METHOD FOR PRODUCING SAME, AND DEVICE FOR PRODUCING SAME

(57) Problems to be solved of the present invention are to provide a method for producing an organic electroluminescent device capable of producing an organic electroluminescent device having long lifetime, an organic electroluminescent device having long lifetime, a planar light source, an illumination apparatus and a display apparatus each having long lifetime. Means for solving the problem is a method for producing an organic electroluminescent device comprising a first electrode, a second electrode and a light emitting layer arranged between the first and second electrodes, the light emitting layer containing an organic film, the method comprising a step of applying a solution containing an organic compound onto the surface of a layer which is to be located just below the light emitting layer, to form the organic film in a dark place.

[Figure 5]

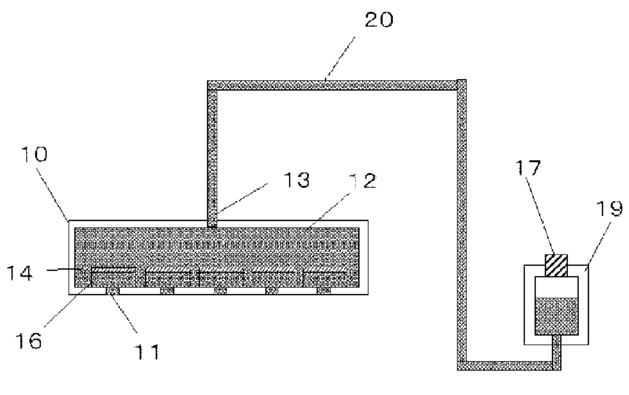


EP 2 533 609 A1

## Description

TECHNICAL FIELD

The present invention relates to an organic electroluminescent device, as well as method and apparatus for producing the same.

BACKGROUND ART

In recent years, an organic electroluminescent display using an organic electroluminescent (hereinafter also referred to as "organic EL") device has been attracting attention. An organic EL device used in the organic EL display is constituted by including an anode, a cathode, and a light emitting layer which is arranged between the anode and the cathode, wherein holes and electrons which are injected from the anode and the cathode, respectively, are bound in the light emitting layer, thereby light is emitted.

The organic EL device has an advantage that it is simply produced, and can form a light emitting layer by an applying method which is easy in scaling the area up. Specifically, the light emitting layer may be produced by forming an applied film using an organic solution containing materials, which are to be included in the light emitting layer, and then drying the formed applied film. As the production method of the organic EL device, there has been proposed methods, for example, a production method of forming a light emitting layer via wet process under a circumstance where light having wavelengths less than 500 nm is shielded with the purpose of improving device properties such as device lifetime (Patent Document 1); and a production method of an organic electroluminescent device comprising a process of producing an organic electroluminescent compound layer comprising a phosphorescent polymer compound under an condition which satisfies the relationship represented by the formula:

$$I \times T = 300 \text{ (lux·second)}$$

wherein I represents an illumination of light consisting of wavelength components shorter than 500 nm and T represents a time of exposing the phosphorescent polymer compound to the light;
under a circumstance where an oxygen concentration is not more than 0.1% by weight and a dew point is less than -40°C (Patent Document 2).

BACKGROUND DOCUMENTS

PATENT DOCUMENTS

Patent Document 1: Japanese Patent Laid-Open Publication No. 2004-55333
Patent Document 2: Japanese Patent Laid-Open Publication No. 2007-165605

DISCLOSURE OF THE INVENTION

PROBLEMS TO BE SOLVED BY THE INVENTION

However, the organic EL device which was produced through the production methods using the conventional techniques fails to have a sufficient length of lifetime, so that an organic EL device having long lifetime is expected.

The present invention is aimed at providing a method for the production of an organic EL device which is capable of producing an organic EL device having long lifetime as well as at providing an organic EL device having long lifetime and a planar light source, an illumination apparatus and a display apparatus each having long lifetime.

MEANS FOR SOLVING THE PROBLEMS

In view of the aforementioned problems, the present inventors intensively studied and, as a result, have accomplished the present invention by finding out that the lifetime of an organic EL device can be lengthened by producing the organic EL device through a production method comprising a process of forming a light emitting layer on an electrode in the dark place.

That is, the present invention provides a method for producing an organic electroluminescent device comprising a first electrode, a second electrode and a light emitting layer arranged between the first and second electrodes, the light emitting layer containing an organic film, the method comprising a step of applying a solution containing an organic compound onto the surface of a layer which is to be located just below the light emitting layer, to form the organic film in a dark place.

In one embodiment, the first electrode is an anode.

In one embodiment, the organic film is formed under an atmosphere containing an inert gas.

In one embodiment, the organic film is formed under an atmosphere which has an oxygen concentration of not more than 10 ppm by volume and/or a moisture concentration of not more than 10 ppm by volume.

In one embodiment, the organic film is formed under an air atmosphere.

In one embodiment, the method comprises a step of baking the organic film.

In one embodiment, the organic film is baked under an atmosphere which contains an inert gas.

In one embodiment, the organic film is baked under a reduced pressure not more than 10Pa.

In one embodiment, the organic EL device comprises a functional layer which is in contact with the light emitting layer.

In one embodiment, the device has the functional layer between the light emitting layer and the first electrode.

In one embodiment, the functional layer comprises a polymer compound.

In one embodiment, the organic compound is a polymer compound.

In one embodiment, the solution containing an organic compound is a solution which has been stored in the dark place.

In one embodiment, the solution containing an organic compound is a solution in which the organic compound is dissolved in a solvent in the dark place.

The present invention provides an organic electroluminescent device produced by the above method for producing the organic electroluminescent device.

The present invention also provides a planar light source comprising the organic electroluminescent device.

The present invention also provides a display apparatu comprising the organic electroluminescent device.

The present invention also provides an illumination apparatus comprising the organic electroluminescent device.

The present invention also provides an apparatus for producing an organic electroluminescent device comprising a first electrode, a second electrode and a light emitting layer arranged between the first and second electrodes, which light emitting layer containing an organic film, wherein the apparatus comprises a tank for storing a solution containing an organic compound; a conduit through which the solution is fed from within the tank to outside the tank; and an applying means that receives the solution containing the organic compound from the conduit and applies the solution containing the organic compound onto the surface of a layer which is to be located just below the light emitting layer to form the organic film in a dark place, wherein at least one of the tank and the conduit has light shielding property.

## EFFECT OF THE INVENTION

According to the present invention, an organic electroluminescent device having long lifetime is capable of being accomplished. Since the above-mentioned organic electroluminescent device is suitably used for a planar or curved light source being used for illumination; a display apparatus such as a segment display apparatus and a dot matrix display apparatus; and a backlight of a liquid crystal display apparatus and the like, the present invention is industrially very important.

## BRIEF DESCRIPTION OF THE DRAWINGS

Fig.1 is a cross-sectional view schematically showing a structure of one embodiment of the organic EL device of the present invention.

Fig.2 is a cross-sectional view schematically showing a structure of another embodiment of the organic EL device of the present invention.

Fig. 3 shows a graph which illustrates the spectrum of yellow light.

Fig. 4 shows a graph which illustrates the spectrum of red light.

Fig. 5 is a schematic view illustrating the structure of an apparatus for producing an organic electroluminescent device in one embodiment of the present invention.

Fig. 6-a shows a graph which illustrates changes in PL fluorescence quantum yield (PLQE) of solutions which were stored under a light-exposed condition and a light-shielded condition, respectively.

Fig. 6-b shows a graph which illustrates the relationship between PL fluorescence quantum yield (PLQE) and light

emitting efficiency (initial characteristic) at the initial condition of an organic electroluminescent device.

EMBODIMENT FOR CONDUCTING THE INVENTION

Fig. 1 is a cross-sectional view schematically showing an organic EL device 1 in one embodiment of the present invention. The organic EL device is generally mounted on a substrate 2 and comprises a first electrode 3, a second electrode 7 and a light emitting layer 6.

By taking the organic EL device 1 shown in Fig. 1 as an example, the step of forming the light emitting layer 6 will be described below, and the details of other constituent elements of the organic EL device 1 will be described later.

The light emitting layer 6 is formed from an organic film which contains an organic compound such as a light emitting material. The light emitting layer 6 is obtained by applying a solution containing the organic compound onto the surface of the first electrode 3, which will be located below the light emitting layer and forming an organic film in the dark place.

The "dark place" in the above means a circumstance where visible light (light having wavelength components in the range from 380 nm to 780 nm) is shielded and an illuminance measured using HIOKI lux HI TESTER 3421 (Tradename, available from Hioki E.E. CORPORATION, illuminometer) is not more than 10 lux. From the viewpoint of lengthening the lifetime of the organic EL device, the illuminance in the dark place is preferably not more than 1 lux and more preferably 0 lux.

The description "forming an organic film" means that the applied solution is solidified into a film or the like so that the organic compound shows no fluidity. For example, at least one of the processes of applying the solution containing the organic compound onto the surface of the first electrode and drying the applied solution containing the organic compound by evaporating a solvent from the solution corresponds to the process of forming an organic film in the embodiments of the present invention.

The formed organic film may be baked thereafter. The process of baking an organic film, which has been once formed, does not correspond to the process of forming an organic film in the embodiments of the present invention. However, it is preferable that such a baking process is performed in the dark place.

From the viewpoint of easiness in producing the organic EL device, the organic layer is preferably formed under an atmospheric pressure environment or under an atmosphere containing an inert gas. Examples of the inert gas include helium gas, argon gas, nitrogen gas, and a mixed gas thereof and nitrogen gas is preferable among them from the viewpoint of easiness in producing the device,

The organic film may be formed, for example, under an atmospheric environment, or under an atmosphere in which the concentration of the inert gas in the atmosphere is usually not less than 99% as expressed by a volumetric ratio. It is preferable that the organic film is formed under an atmosphere in which the concentration of the inert gas is not less than 99.5% from the viewpoint of increasing device lifetime.

From the viewpoint of easiness in producing the device, it is preferable that the organic film is formed under an atmosphere in which the oxygen concentration is not more than 1000 ppm as expressed by a volumetric ratio and/or the moisture concentration is not more than 1000 ppm as expressed by a volumetric ratio, and it is further preferable that the organic film is formed under an atmosphere in which the oxygen concentration is not more than 10 ppm as expressed by a volumetric ratio and/or the moisture concentration is not more than 10 ppm as expressed by a volumetric ratio.

Then, it is preferable that the organic film is baked in the condition where the oxygen concentration and the moisture concentration are each retained not more than 1000 ppm as expressed by a volumetric ratio. By the above baking, the solvent contained in the organic film is removed and, as a result, an organic film containing no or very little solvent is formed.

From the viewpoint of light emitting property and lifetime property of the device, it is preferable that the baking is performed at a temperature in a range from 50°C to 250°C. A baking time is appropriately selected depending on the components of the finally formed organic film, that is, the organic film contained in the light emitting layer 6, and is, for example, usually around from 5 minutes to 2 hours.

It is preferable that the baking of the organic layer is performed under an atmosphere containing an inert gas, from the viewpoint of increasing lifetime of the organic EL device. Examples of the inert gas include helium gas, argon gas, nitrogen gas, and a mixed gas thereof and, among them, nitrogen gas is preferable from the viewpoint of easiness in device production. These inert gases are introduced into an accommodation apparatus for accommodating a device precursor. A concentration of the inert gas in the atmosphere is usually not less than 99%, preferably not less than 99.5% as expressed by a volumetric ratio.

In addition, from the viewpoint of light emitting property and lifetime property of the organic EL device, it is preferable that the formation of the organic layer and baking of the organic layer are performed in the state where the oxygen concentration and the moisture concentration in the atmosphere are retained at not more than 600 ppm as expressed by a volumetric ratio, respectively, it is more preferable that the oxygen concentration and the moisture

concentration are not more than 300 ppm as expressed by a volumetric ratio, respectively, it is further preferable that the oxygen concentration and the moisture concentration are not more than 100 ppm as expressed by a volumetric ratio, respectively, and it is particularly preferable that the oxygen concentration and the moisture concentration are not more than 10 ppm as expressed by a volumetric ratio, respectively.

In addition, it is preferable that the baking of the organic film is performed under a pressure at not more than 10 Pa, from the viewpoint of increasing lifetime of the organic EL device. It is preferable that baking of the organic film is performed in an accommodation apparatus into which an inert gas is introduced and, at the same time, where pressure is reduced. When baking is performed under a pressure-reduced atmosphere, the solvent contained in the organic film can be removed more as compared with baking under the atmospheric pressure.

When the solution containing the organic compound is stored in the dark place, the light emitting efficiency (PLQE) in the case where the solution containing the organic compound is stored in the dark place is higher than the efficiency in the case where the solution containing the organic compound is stored under illumination according to the results of the experiments performed by the inventors. Thus, it is preferable that the solution containing the organic compound is stored in the dark place regardless of the condition of the solvent and the condition of the organic compound which is a powder before being dissolved.

The inventors performed experiments to confirm the results of the case where the process of applying the solution and forming the light emitting layer is performed in the dark place. Specifically, one sample of the solution, in which the organic compound was dissolved, was stored while being exposed to a light of fluorescent lamp for 6 days and another sample of the solution was stored while being light-shielded in the dark place for 6 days and then each PLQE of the solutions was measured. Each PLQE of the solutions was measured using Absolute Fluorescence Quantum Yield measuring apparatus C9920-01 (manufactured by Hamamatsu Photonics) under the condition where after removing oxygen in the solution by substituting with nitrogen, the above solution in a quartz cell was irradiated with an excitation light having a wavelength of 365 nm under a nitrogen atmosphere.

Fig. 6-a illustrates change in PL fluorescence quantum yield (PLQE) of the solutions which were stored under respective conditions. As illustrated, in the case where the solution in which the organic compound was dissolved was stored while being light-shielded in the dark place for 6 days, no change of PLQE was found. On the other hand, in the case where the solution was stored while being exposed to a light of fluorescent lamp, the value of PLQE decreased along the length of storing and, after 6 days, the value of PLQE decreased by 10% as compared with the case where the solution was stored in the dark place.

Fig. 6-b illustrates the relationship between PLQE and light emitting efficiency (initial characteristic) at the initial condition of an organic electroluminescent device. Each PLQE in Fig. 6-b was measured using Absolute Fluorescence Quantum Yield measuring apparatus C9920-01 (manufactured by Hamamatsu Photonics) under the condition where an organic film, which was formed by applying the solution, was irradiated with an excitation light having a wavelength of 365 nm under a nitrogen atmosphere. As illustrated, there is a directly proportional correlation between the PLQE and the light emitting efficiency, so that an effect on the light emitting efficiency may be estimated based on the measured results of the PLQE.

From the above, it is contemplated that the lowering of the light emitting efficiency due to irradiation of light to the solution may be inhibited by storing the solution in the dark place or leaving the solution being irradiated with no light during the production process.

When the solution containing the organic compound is stored in the dark place, the light emitting efficiency (PLQE) in the case where the solution containing the organic compound is stored in the dark place is higher than the efficiency in the case where the solution containing the organic compound is stored under illumination according to the results of the experiments performed by the inventors. Thus, it is preferable that the solution containing the organic compound is stored in the dark place regardless of the condition of the solvent and the condition of the organic compound which is a powder before being dissolved.

Therefore, it is preferable that the solution containing the organic compound is prepared in the dark place.

By forming the second electrode 7 onto the light emitting layer 6 after formation of an organic film contained in the light emitting layer 6, the organic EL device 1 is produced.

Generally, the first electrode 3 in the organic EL device 1 is an anode and the second electrode 7 is a cathode.

In one embodiment of the present invention, the organic EL device 1 may further comprise a hole transporting layer 5 as a functional layer being adjacent to the hole injecting layer 4 and the light emitting layer 6 as shown in Fig. 2. The organic EL device 1 may be constituted with a first electrode 3, a hole injecting layer 4, a hole transporting layer 5, a light emitting layer 6 and a second electrode 7 by laminating the above layers in this order. The organic EL device 1 is produced by stacking the first electrode 3, the hole injecting layer 4, the hole transporting layer 5, the light emitting layer 6 and the second electrode 7 onto the substrate 2 in sequence.

The light emitting layer 6 is obtained by applying a solution containing the organic compound onto the surface of the hole transporting layer 5, which will be located below the light emitting layer and forming an organic film in the dark place.

By taking the organic EL device shown in Fig. 2 as an example, the step of forming the functional layer will be described below, and the details of other constituent elements of the organic EL device will be described later.

The functional layer in the present invention means a layer, which is adjacent to the light emitting layer, which usually does not concern with the light emission of the hole injecting layer, the hole transporting layer, the electron injecting layer, the electron transporting layer and the like, and which has a function of injecting or transporting charges.

In the case where the first electrode is an anode, examples of the functional layer, which is located between the light emitting layer and the first electrode, include a hole injecting layer or a hole transporting layer. Further, examples of the functional layer located between the light emitting layer and the second electrode include an electron injecting layer, an electron transporting layer and it is preferable that the functional layer is located between the light emitting layer and the second electrode.

By taking the hole transporting layer 5 as an example, the process of forming the organic film contained in the functional layer will be described below. The organic film is obtained by, after forming the first electrode 3 and the hole injecting layer 4 onto the substrate 2, applying the solution containing the organic compound onto the hole injecting layer 4 and forming an organic film. From the viewpoint of applicability, it is preferable that the organic compound is a polymer compound.

It is preferable that the organic film is formed under the atmospheric pressure or under an atmosphere containing an inert gas, in that the organic EL device can be easily produced. Examples of the inert gas include helium gas, argon gas, nitrogen gas, and a mixed gas thereof and, among them, nitrogen gas is preferable from the viewpoint of easiness in device production.

The organic film may be formed, for example, under an atmospheric environment, or under an atmosphere in which a concentration of the inert gas in the atmosphere is usually not less than 99% as expressed by a volumetric ratio. It is preferable that the organic film is formed under an atmosphere in which the concentration of the inert gas is not less than 99.5% from the viewpoint of increasing device lifetime.

From the viewpoint of easiness in producing the device, it is preferable that the organic film is formed under an atmosphere in which the oxygen concentration is not more than 1000 ppm as expressed by a volumetric ratio and/or the moisture concentration is not more than 1000 ppm as expressed by a volumetric ratio, and it is further preferable that the organic film is formed under an atmosphere in which the oxygen concentration is not more than 10 ppm as expressed by a volumetric ratio and/or the moisture concentration is not more than 10 ppm as expressed by a volumetric ratio.

Then, it is preferable that the organic film is baked in the condition where the oxygen concentration and the moisture concentration are each retained not more than 1000 ppm as expressed by a volumetric ratio. By the above baking, the solvent contained in the organic film is removed.

From the viewpoint of light emitting property and lifetime property of the device, it is preferable that the baking is performed at a temperature in a range of from 50°C to 250°C. A baking time is appropriately selected depending on the components of the organic film contained in the hole transporting layer 5, and is, for example, usually around from 5 minutes to 2 hours.

It is preferable that the baking of the organic layer is performed under an atmosphere containing an inert gas, from the viewpoint of increasing lifetime of the organic EL device. Examples of the inert gas include helium gas, argon gas, nitrogen gas, and a mixed gas thereof and, among them, nitrogen gas is preferable from the viewpoint of easiness in device production. The inert gas is introduced into an accommodation apparatus for accommodating a device precursor. A concentration of the inert gas in the atmosphere is usually not less than 99%, preferably not less than 99.5% as expressed by a volumetric ratio.

In addition, it is preferable that the baking of the organic film is performed under a pressure at not more than 10 Pa, from the viewpoint of increasing lifetime of the organic EL device. It is preferable that baking of the organic film is performed in an accommodation apparatus into which an inert gas is introduced and, at the same time, where pressure is reduced.

In addition, from the viewpoint of light emitting property and lifetime property of the organic EL device, it is preferable that the formation of the organic layer and baking of the organic layer are performed in the state where the oxygen concentration and the moisture concentration in the atmosphere are retained at not more than 600 ppm as expressed by a volumetric ratio, respectively, it is more preferable that the oxygen concentration and the moisture concentration are not more than 300 ppm as expressed by a volumetric ratio, respectively, it is further preferable that the oxygen concentration and the moisture concentration are not more than 100 ppm as expressed by a volumetric ratio, respectively, and it is particularly preferable that the oxygen concentration and the moisture concentration are not more than 10 ppm as expressed by a volumetric ratio, respectively.

After forming the organic film of the hole transporting layer 5, an organic film contained in the light emitting layer 6 is formed on the organic film contained in the hole transporting layer 5 according to the above-mentioned process, followed by forming the second cathode 7 thereon and the organic EL device 1 is produced.

Device constitutions of the organic EL device, and each constituent element will be described in more detail

below.

The organic EL device of the present invention has a first electrode, a second electrode, and a light emitting layer arranged between the first electrode and the second electrode, as essential constituent features. In addition, an additional functional layer in addition to the light emitting layer, the functional layer is provided between the first electrode (e.g. anode) and the second electrode (e.g. cathode), for example, for improving device properties, in some cases.

Examples of the functional layer provided between the cathode and the light emitting layer include an electron injecting layer, an electron transporting layer, a hole blocking layer and the like. In addition, when both layers of the electron injecting layer and the electron transporting layer are provided between the cathode and the light emitting layer, a layer being in contact with the cathode is referred to as an electron injecting layer, and layers except for this electron injecting layer are referred to as electron transporting layers, in some cases.

The electron injecting layer is a layer having the function of improving an efficiency of electron injection from the cathode. The electron transporting layer is a layer having the function of improving electron injection from the cathode, the electron injecting layer or the electron transporting layer closer to the cathode. The hole blocking layer is a layer having the function of blocking transportation of holes. In addition, when the electron injecting layer and / or the electron transporting layer have the function of blocking transportation of holes, these layers also serve as the hole blocking layer, in some cases.

It can be confirmed, for example, by producing a device which flows only a hole current that the hole blocking layer has the function of blocking transportation of holes. For example, when a device which is not provided with the hole blocking layer, and flows only a hole current, and a device having a constitution that the hole blocking layer is inserted into the above device are produced, it can be confirmed that the hole blocking layer exhibits the function of blocking transportation of holes by decreasing a current value of the device provided with the hole blocking layer.

Examples of the functional layer provided between the anode and the light emitting layer include a hole injecting layer, a hole transporting layer, an electron blocking layer and the like. In the case where both the hole injecting layer and the hole transporting layer are located between the anode and the light emitting layer, the layer adjacent to the anode is referred to as the hole injecting layer and the layer other than the hole injecting layer is referred to as the hole transporting layer, in some cases.

The hole injecting layer is a layer having the function of improving an efficiency of hole injection from the anode. The hole transporting layer is a layer having the function of improving hole injection from the anode, the hole injecting layer, or the hole transporting layer closer to the anode. The electron blocking layer is a layer having the function of blocking transportation of electrons. In addition, when the hole injecting layer and /or the hole transporting layer have the function of blocking transportation of electrons, these layers also serve as the electron blocking layer, in some cases.

It can be conformed, for example, by producing a device which flows only an electron current that the electron blocking layer has the function of blocking transportation of electrons. For example, when a device which is not provided with the electron blocking layer, and flows only an electron current, and a device having a constitution that the electron blocking layer is inserted into the above device are produced, it can be confirmed that the electron blocking layer exhibits the function of blocking transportation of electrons by decease in a current value of the device provided with the electron blocking layer.

One example of device constitutions which can be taken by the organic EL device of the present embodiment will be shown below.

a) Anode / hole injecting layer / light emitting layer / cathode
b) Anode / hole injecting layer / light emitting layer / electron injecting layer / cathode
c) Anode / hole injecting layer / light emitting layer / electron transporting layer / cathode
e) Anode / hole injecting layer / light emitting layer / electron transporting layer / electron injecting layer / cathode
f) Anode / hole transporting layer / light emitting layer / cathode
d) Anode / hole transporting layer / light emitting layer / electron injecting layer / cathode
e) Anode / hole injecting layer / light emitting layer / electron transporting layer / cathode
f) Anode / hole transporting layer / light emitting layer / electron transporting layer / electron injecting layer / cathode
g) Anode / hole injecting layer / hole transporting layer / light emitting layer / cathode
h) Anode / hole injecting layer / hole transporting layer / light emitting layer / electron injecting layer / cathode
i) Anode / hole injecting layer / hole transporting layer / light emitting layer /electron transporting layer / cathode
j) Anode / hole injecting layer / hole transporting layer / light emitting layer /electron transporting layer / electron injecting layer / cathode
k) Anode / light emitting layer / electron injecting layer / anode
l) Anode / light emitting layer / electron transporting layer cathode
m) Anode / light emitting layer / electron transporting layer / electron injecting layer / cathode

(wherein, a symbol "/" indicates that respective layers holding the symbol "/" is laminated as being adjacent to each

other. The same shall apply hereinafter.)

The organic EL device may have two or more layers of light emitting layers. In each constitution shown in a) to m), when a layer provided between the anode and the cathode is defined as "repeating unit A", respectively, an example of an organic EL device having two layers of light emitting layers includes a device constitution shown in the following n).

n) Anode / (repeating unit A) / charge generating layer / (repeating unit A) /cathode

In addition, when "(repeating unit A) / charge generating layer" is defined as "repeating unit B", a specific example of an organic EL device having three or more layers of light emitting layers includes a device constitution shown in the following o).

o) Anode / (repeating unit B)$_x$ / (repeating unit A) / cathode

Here, a symbol "x" represents an integer of not less than 2, and "(repeating unit B)$_x$" represents a constitution in which (repeating unit B)s are laminated to the number of "x". The charge generating layer is a layer in which holes and electrons are generated by applying the electric filed. Examples of the charge generating layer include thin films composed of vanadium oxide, indium tin oxide (abbreviation ITO), molybdenum oxide and the like.

The organic EL device may be further covered with a sealing member such as a sealing film or a sealing plate for sealing. When the organic EL device is provided on a substrate, an anode is usually arranged on a substrate side, but a cathode may be arranged on a substrate side.

In the organic EL device of the present embodiment, in order to take out light generated in the interior, usually, all layers arranged on a side of taking out light based on the light emitting layer are made to be transparent. It is preferable that an extent of transparency is such that a visible light transmittance between the outermost surface of the organic EL device on the side of taking out light, and the light emitting layer is not less than 40%. In the case of the organic EL device which is required to emit light in an ultraviolet region or an infrared region, it is preferable that a light transmittance of not less than 40% in the region is exhibited.

In the organic EL device of the present embodiment, an insulating layer having a film thickness of not more than 2 nm may be further provided adjacent to the electrode, in order to improve adherability with the electrode and to improve property of charge injection from the electrode. In addition, in order to improve adherability at an interface and prevent mixing, a thin buffer layer may be inserted between the aforementioned respective layers.

An order and the layer number of layers to be laminated, and a thickness of each layer can be appropriately set in view of a light emitting efficiency and a device lifetime.

Then, a material of, and a method of forming each layer constituting the organic EL device will be more specifically described.

<Substrate>

As a the substrate, a material which does not chemically change in the step of producing the organic EL device is preferably used and, for example, a glass, a plastic, a polymer film, and a silicon substrate as well as a laminate thereof are used. As the substrate, commercialized products are available, or the substrate can be produced by a publicly known method.

<Anode>

As the anode, in the case of an organic EL device having a constitution that light from the light emitting layer is taken out through the anode, a transparent or translucent electrode is used. As the transparent electrode or the translucent electrode, a thin film of metal oxide, metal sulfide and a metal having high electric conductivity can be used, and a thin film having high light transmittance is preferably used. Specifically, thin films composed of indium oxide, zinc oxide, tin oxide, ITO, indium zinc oxide (abbreviation IZO), gold, platinum, silver, and copper are used and, among them, thin films composed of ITO, IZO, or tin oxide are preferably used. Examples of a method for producing the anode include a vacuum deposition method, a sputtering method, an ion plating method, and a plating method. Further, as the anode, an organic transparent electrically conductive film of polyaniline or a derivative thereof, or polythiophene or a derivative thereof may be used.

In the anode, a material which reflects light may be used and, as the material, a metal, metal oxide and metal sulfide having a work function of not less than 3.0 eV are preferable.

A film thickness of the anode can be appropriately selected in view of permeability of light and electric conductivity, and is, for example, from 10 nm to 10 μm, preferably from 20 nm to 1 μm, more preferably from 50 nm to 500 nm.

<Hole injecting layer>

Examples of a hole injecting material constituting the hole injecting layer include oxides such as vanadium

oxide, molybdenum oxide, ruthenium oxide and aluminum oxide, as well as phenylamine-based compounds, star burst-type amine-based compounds, phthalocyanine-based compounds, amorphous carbon, polyaniline, and polythiophene derivatives.

Examples of a method of forming a film of the hole injecting layer include film formation from a solution containing the hole injecting material. It is preferable that a film is formed under the same atmosphere as that of the step of forming the adjacent layer as mentioned above from the viewpoint of increasing lifetime. A solvent used in film formation from a solution is not particularly limited as far as it dissolves the hole injecting material, and chlorine-based solvents such as chloroform, methylene chloride, dichloroethane and the like; ether-based solvents such as tetrahydrofuran and the like; aromatic hydrocarbon-based solvents such as toluene, xylene and the like; ketone-based solvents such as acetone, methyl ethyl ketone arid the like; ester-based solvents such as ethyl acetate, butyl acetate, ethyl cellosolve acetate and the like; alcohol-based solvents such as isopropyl alcohol and the like; and water or mixtures thereof and the like can be used.

Examples of a method of forming a film from a solution include applying methods such as a spin coating method, a casting method, a nozzle coating method, a microgravure coating method, a gravure coating method, a bar coating method, a roll coating method, a wire bar coating method, a dip coating method, a spray coating method, a screen printing method, a flexo printing method, an offset printing method, and an inkjet printing method.

A film thickness of the hole injecting layer varies in an optimal value depending on a material used, is appropriately set so that driving voltage and light emitting efficiency become an adequate value, and is necessary a thickness such that at least a pinhole is not generated and, when the film thickness is too large, since the driving voltage of a device becomes higher, and thus this is not preferable. Therefore, the film thickness of the hole injecting layer is, for example, from 1 nm to 1 μm, preferably 2 nm to 500 nm, more preferably from 5 nm to 200 nm.

<Hole transporting layer>

Examples of a hole transporting material constituting the hole transporting layer include polyvinyl carbazole or a derivative thereof, polysilane or a derivative thereof, a polysiloxane derivative having aromatic amine on a side chain or the main chain, a pyrazoline derivative, an arylamine derivative, a stilbene derivative, a triphenyldiamine derivative, polyaniline or a derivative thereof, polythiophene or a derivative thereof, polyarylamine or a derivative thereof, polypyrrole or a derivative thereof, poly(p-phenylenevinylene) or a derivative there of, or poly(2,5-thienylenevinylene) or a derivative thereof.

Among them, as the hole transporting material, polyvinyl carbazole or a derivative thereof, polysilane or a derivative thereof, a polysiloxane derivative having an aromatic amine compound group on a side chain or the main chain, polyaniline or a derivative thereof, polythiophene or a derivative thereof, polyarylamine or a derivative thereof, poly(p-phenylenevinylene) or a derivative thereof, or poly(2,5-thienylenevinylene) or a derivative thereof are preferable, and further preferred are polyvinyl carbazole or a derivative thereof, polysilane or a derivative thereof, a polysiloxane derivative having an aromatic amine compound group on a side chain or the main chain. In the case of a low-molecular hole transporting material, it is preferable to use the material by dispersing it in a polymer binder.

Examples of a method of forming a film of the hole transporting layer are not particularly limited, and in the case of the low-molecular hole transporting material, include film formation from a mixed solution containing the polymer binder and the hole transporting material and, in the case of the high-molecular hole transporting material, include film formation from a solution containing the hole transporting material.

A solvent used in film formation from a solution is not particularly limited as far as it dissolves the hole transporting material, and chlorine-based solvents such as chloroform, methylene chloride, dichloroethane and the like; ether-based solvents such as tetrahydrofuran and the like; aromatic hydrocarbon-based solvents such as toluene, xylene and the like; ketone-based solvents such as acetone, methyl ethyl ketone and the like; ester-based solvents such as ethyl acetate, butyl acetate, ethyl cellosolve acetate and the like can be used.

Examples of a method of forming a film from a solution include the same applying method as the aforementioned method of forming a film of the hole injecting layer and, it is preferable that a film is formed under the same atmosphere as that of the step of forming the adjacent layer as mentioned above from the viewpoint of increasing lifetime.

As the polymer binder to be mixed, a polymer binder which does not extremely inhibit charge transportation is preferable, and a polymer binder which is weak in absorption of visible light is preferably used, and examples thereof include polycarbonate, polylacrylate, polymethyl acrylate, polymethyl methacrylate, polystyrene, polyvinyl chloride, and polysiloxane.

A film thickness of the hole transporting layer varies in an optimal value depending on a material used, is appropriately set so that a driving voltage and light emitting efficiency become an adequate value, and is necessary a thickness such that at least a pinhole is not generated and, when the film thickness is too large, since the driving voltage of a device becomes higher, and thus this is not preferable. Therefore, the film thickness of the hole transporting layer is, for example, from 1 nm to 1 μm, preferably from 2 nm to 500 nm, more preferably from 5 nm to 200 nm.

<Light emitting layer>

The light emitting layer, usually, is constituted with the organic material which mainly emits fluorescence and/or phosphorescence or the organic material and a dopant having an assisting function. The dopant is added, for example, for improving a light emitting efficiency or changing a light emitting wavelength. The organic compound may be a low-molecular compound or a polymer compound as far as it is capable of forming a film by an application method, and the light emitting layer preferably comprises a polymer compound having a polystyrene-equivalent number average molecular weight of from $10^3$ to $10^8$. Examples of the light emitting material constituting the light emitting layer include, for example, a polymer-based material.

(polymer-based material)

Examples of the polymer-based material include polyparaphenylenevinylene derivatives, polythiophene derivatives, polyp araphenylene derivatives, polysilane derivatives, polyacetylene derivatives, polyfluorene derivatives, polyvinylcarbazole derivatives, and pigment-based dopant materials and metal complex-based dopant materials, which have been high-molecularized, as exemplified below.

Among the light emitting materials, examples of a material which emits blue light include distyrylarylene derivatives, oxadiazole derivatives, and polymers thereof, polyvinylcarbazole derivatives, polyparaphenylene derivatives, and polyfluorene derivatives. Among them, polyvinylcarbazole derivatives, polyparaphenylene derivatives and polyfluorene derivatives, which are high-molecular materials, are preferable.

In addition, examples of a material which emits green light include quinacridone derivatives, coumarin derivatives, and polymers thereof, polyparaphenylenevinylene derivatives and polyfluorene derivatives. Among them, polyparaphenylenevinylene derivatives and polyfluorene derivatives, which are high-molecular materials, are preferable.

In addition, examples of a material which emits red light include coumarin derivatives, thiophene ring compounds, and polymers thereof, polypaxaphenylenevinylene derivatives, polythiophene derivatives, and polyfluorene derivatives. Among them, polyparaphenylenevinylene derivatives, polythiophene derivatives, and polyfluorene derivatives, which are high-molecular materials, are preferable.

(Dopant materials)

Examples of the pigment-based dopant materials include cyclopendamine derivatives, tetraphenylbutadiene derivative compounds, triphenylamine derivatives, oxadiazole derivatives, pyrazoloquinoline derivatives, distyrylbenzene derivatives, distyrylarylene derivatives, pyrrole derivatives, thiophene ring compounds, pyridine ring compounds, perinone derivatives, perylene derivatives, oligothiophene derivatives, trifumanylamine derivatives, oxadiazole dimers, pyrazoline dimers, quinacridone derivatives, coumarin derivatives, rubrene derivatives, squalium derivatives, porphyrin derivatives, tetracene derivatives, pyrazolone derivatives, decacyclene, and phenoxazone.

Examples of the metal complex-based dopant materials include metal complexes having Al, Zn, Be and the like., or rare earth metals such as Tb, Eu and Dy as a central metal, and having an oxadiazole, thiadiazole, phenylpyridine, phenylbenzimidazole or quinoline structure as a ligand. Examples of the metal complexes include metal complexes having luminescence from the triplet excited state such as iridium complexes and platinum complexes, aluminum quinolinol complexes, benzoquinolinol beryllium complexes, benzoxazolyl zinc complexes, benzothiazole zinc complexes, azomethyl zinc complexes, porphyrin zinc complexes, and europium complexes.

In addition, a thickness of the light emitting layer is usually from about 2 nm to 200 nm.

As a method of forming a film of the light emitting layer, a film of the light emitting layer is formed by film formation from a solution containing a light emitting material, as described above. As a solvent used in film formation from a solution, the same solvent as that used in film formation of the hole transporting layer from the solution may be used.

A production apparatus for realizing the method for producing the organic EL device in the present embodiment is, for example, an apparatus involving applying means of an inkjet printing method, which has a structure as shown in Fig. 5.

In Fig. 5, the applying means 10 comprises a nozzle 11 for discharging the solution containing the light emitting material; a pressure chamber 16 in liquid communication with the nozzle 11; a piezoelectric element 14 which constitutes part of the pressure chamber 16; a manifold 12 which supplies fluid flow to the pressure chamber 16; and an inlet 13 for the solution which feeds the solution to the manifold 12. The applying means 10 discharges the solution by applying a voltage to the piezoelectric element 14 to deform the element, decreasing the volume of the pressure chamber 16, and thereby pressurizing the solution. The discharged solution is applied onto the surface of the substrate (not shown). The inlet 13 for the solution of the applying means 10 is connected to the tank 19 via a conduit 20 and the solution within the tank 19 is supplied to the applying means 10. The tank 19 is equipped with a pressure feeding mechanism 17 which pumps the solution to the applying means 10. As the pressure feeding mechanism, a pump or a cylinder may be used.

The tank 19 and the conduit 20 are constituted with a stainless steel metal having light-shielding property. The above constitution may be attained by using a material having light-shielding property or a material having a light permeability being coated with a film which has light-shielding property and, specifically, it is capable of preparing the tank 19 with a glass bottle and the surroundings thereof are coated with a black film having light-shielding property. Alternatively, the conduit is constituted with glass, resin tube or the combination thereof and the surroundings thereof are coated with an aluminum metal foil or a black film having light-shielding property.

Thus, it is capable of inhibiting the solution from being irradiated with outside light before being discharged by making the tank and conduit, which store or supply the solution containing the light emitting material, for light-shielding. In this way, it is capable of inhibiting the solution from being irradiated with light even when the application apparatus would not be held in the dark place at the time other than during application such as during maintaining the tank, replacing the conduit and the like. In addition, any part where the solution is present in the application apparatus other than the three parts such as the tank and the conduit. In this case, it is preferable that the constituent elements where the solution is present is made for light-shielding.

Examples of the applying method include not only an inkjet printing method, but also other coating methods such as a spin coating method, a casting method, a microgravure coating method, a gravure coating method, a bar coating method, a roll coating method, a wire bar coating method, a dip coating method, a slit coating method, a capillary coating method, a spray coating method and a nozzle coating method, and applying methods such as a gravure printing method, a screen printing method, a flexo printing method, a reverse printing method and the like. Printing methods such as a gravure printing method, a screen printing method, a flexo printing method, an offset printing method, a reverse printing method, and an inkjet printing method are preferable in that pattern formation and color-coding of multiple colors are easily performed.

In the above-mentioned printing method, the same effect as the inkjet printing method can be obtained by making the conduit and the tank, which contain the solution containing the light emitting material, for light-shielding.

When the tank which stores the solution containing the organic compound or the conduit which supplies the solution from the tank to the applying means has light-shielding property, the light emitting efficiency of the organic EL device can be kept in a good state in the case where the tank or the conduit has the light-shielding property rather than that in the case where the tank or the conduit has the transparency, even when the applying apparatus is located not in the dark place at the time other than during application such as during maintaining the applying apparatus.

<Electron transporting layer>

As an electron transporting material constituting the electron transporting layer, known electron transporting materials can be used, and examples thereof include an oxadiazole derivative, anthraquinodimethane or a derivative thereof, benzoquinone or a derivative thereof, naphthoquinone or a derivative thereof, anthraquinone or a derivative thereof, tetracyanoanthraquinodimethane or a derivative thereof, a fluorenone derivative, diphenyldicyanoethylene or a derivative thereof, a diphenoquinone derivative, or a metal complex of 8-hydroxyquinoline or a derivative thereof, polyquinoline or a derivative thereof, polyquinoxaline or a derivative thereof, and polyfluorene or a derivative thereof.

Among them, as the electron transporting material, an oxadiazole derivative, benzoquinone or a derivative thereof, anthraquinone or a derivative thereof, or a metal complex of 8-hydroxyquinoline or a derivative thereof, polyquinoline or a derivative thereof, polyquinoxaline or a derivative thereof, and polyfluorene or a derivative thereof are preferable, and 2-(4-biphenylyl)-5-(4-tert-butylphenyl)-1,3,4-oxadiazole, benzoquinone, anthraquinone, tris(8-quinolinol) aluminum, and polyquinoline are further preferable.

A method of forming a film of the electron transporting layer is not particularly limited, but in the case of a low-molecular electron transporting material, examples thereof include a method of vacuum deposition from a powder, or film formation from a solution or molten state and, in the case of a high-molecular electron transporting material, examples thereof include film formation from a solution or molten state. In addition, in the case of film formation from a solution or the molten state, a polymer binder may be used in combination. Examples of a method of forming a film of the electron transporting layer from a solution include the same method of forming a film as the method of forming a film of the hole transporting layer from a solution, and it is preferable that the film is formed under the same atmosphere as that of the step of forming an adjacent layer.

A film thickness of the electron transporting layer varies in an optimal value depending on a material used, is appropriately set so that driving voltage and light emitting efficiency become an adequate value, and is necessary a thickness such that at least a pinhole is not generated and, when the film thickness is too large, since the driving voltage of a device becomes higher, and thus this is not preferable. Therefore, the film thickness of the electron transporting layer is, for example, from 1 nm to 1 μm, preferably from 2 nm to 500 nm, more preferably from 5 nm to 200 nm.

<Electron injecting layer>

As a material constituting the electron injecting layer, an optimal material is appropriately selected depending on a kind of the light emitting layer, and examples thereof include an alkali metal, an alkaline earth metal, an alloy containing one or more kinds of alkali metal and alkaline earth metal, an oxide, halide, and carbonate of an alkali metal or an alkaline earth metal, or a mixture of these metals. Examples of the alkali metal, and oxide, halide and carbonate of the alkali metal include lithium, sodium, potassium, rubidium, cesium, lithium oxide, lithium fluoride, sodium oxide, sodium fluoride, potassium oxide, potassium fluoride, rubidium oxide, rubidium fluoride, cesium oxide, cesium fluoride, and lithium carbonate. In addition, examples of the alkaline earth metal, and oxide, halide and carbonate of the alkaline earth metal include magnesium, calcium, barium, strontium, magnesium oxide, magnesium fluoride, calcium oxide, calcium fluoride, barium oxide, barium fluoride, strontium oxide, strontium fluoride and magnesium carbonate. The electron injecting layer may be constituted with a laminate in which two or more layers are laminated, and examples thereof include LiF/Ca. The electron injecting layer is formed by a deposition method, a sputtering method, a printing method and the like. As a film thickness of the electron injecting layer, it is preferable from around 1 nm to 1 μm.

<Cathode>

As a material of the cathode, materials which have a small work function, easily inject electrons into the light emitting layer, and have high electrical conductivity are preferable. In addition, in an organic EL device in which light is taken out from an anode side, since light from the light emitting layer is reflected with the cathode to an anode side, as a material of the cathode, materials having high visible light reflectivity are preferable. In the cathode, for example, an alkali metal, an alkaline earth metal, a transition metal and a Group III-B metal can be used. As the material of the cathode, for example, metals such as lithium, sodium, potassium, rubidium, cesium, beryllium, magnesium, calcium, strontium, barium, aluminum, scandium, vanadium, zinc, yttrium, indium, cerium, samarium, europium, terbium and ytterbium, alloys of two or more kinds of the above metals, alloys of one or more kinds of the above metals and one or more kinds of gold, silver, platinum, copper, manganese, titanium, cobalt, nickel, tungsten, and tin, or graphite or a graphite intercalation compound are used. Examples of the alloys include a magnesium-silver alloy, a magnesium-indium alloy, a magnesium-aluminum alloy, an indium-silver alloy, a lithium-aluminum alloy, a lithium-magnesium alloy, a lithium-indium alloy, and a calcium-aluminum alloy. In addition, as the cathode, a transparent electrically conductive electrode composed of an electrically conductive metal oxide and an electrically conductive organic substance can be used. Specifically, examples of the electrically conductive metal oxide include indium oxide, zinc oxide, tin oxide, ITO, and IZO, and examples of the electrically conductive organic substance include polyaniline or a derivative thereof, polythiophene or a derivative thereof. In addition, the cathode may be constituted with a laminate in which two or more layers are laminated. In addition, the electron injecting layer is used as the cathode, in some cases.

A film thickness of the cathode is appropriately set in view of electric conductivity and durability, and is, for example, from 10 nm to 10 μm, preferably from 20 nm to 1 μm, and more preferably from 50 nm 500 nm.

Examples of a method for producing the cathode include a vacuum deposition method, a sputtering method, and a lamination method of thermally pressing a metal thin film.

<Insulating layer>

Examples of a material of the insulating layer include metal fluoride, metal oxide, and an organic insulating material. Examples of an organic EL device in which an insulating layer having a film thickness of not more than 2 nm is provided include a device in which an insulating layer having a film thickness of not more than 2 nm is provided adjacent to the cathode, and a device in which an insulating layer having a film thickness of not more than 2 nm is provided adjacent to the anode.

The above-described organic EL device can be preferably used in curved or planar illumination apparatuses, for example, a planar light source used as a light source of a scanner, and a display apparatus.

Examples of the display apparatus provided with the organic EL device include an active matrix display apparatus, a passive matrix display apparatus, a segment display apparatus, a dot matrix display apparatus and a liquid crystal display apparatus. In addition, the organic EL device is used as a light emitting device constituting each pixel in the active matrix display apparatus and the passive matrix display apparatus, is used as a light emitting device constituting each segment in the segment display apparatus, and is used as a backlight in the dot matrix display apparatus and the liquid crystal display apparatus.

EXAMPLES

The present invention will be described in more detail below by way of examples, but is not limited to the

following examples.

(Example 1)

An organic EL device having the following constitution was produced.
"Glass substrate / ITO (150 nm) / Baytron P (65 nm) / polymer compound 1 (20 nm) / polymer compound 2 (65 nm) / NaF (4 nm) / Al (80 nm)"

A suspension of poly(3,4)ethylenedioxythiophene / polystyrene sulfonic acid (manufactured by Starck; Baytorn P) was applied to a glass substrate on which an ITO film (anode) having a thickness of 150 nm had been formed by a sputtering method, by a spin coating method to form a thin film having a thickness of 65 nm and, further, the thin film was baked by heating on a hot plate at 200°C for 10 minutes to obtain a hole injecting layer. In addition, in formation of the hole injecting layer, the steps of forming and baking the film were performed under an atmospheric environment.

Then, a polymer compound 1 which is a hole transporting material was dissolved in xylene to produce a xylene solution 1. A concentration of the polymer compound 1 in this xylene solution 1 was made to be 0.8% by weight. Then, under a nitrogen atmosphere in which an oxygen concentration and a moisture concentration were each controlled at not more than 10 ppm as expressed by a volumetric ratio, the xylene solution 1 was applied to the hole injecting layer by a spin coating method to form a thin film for a hole transporting layer having a film thickness of 20 nm, and the thin film was baked by heating at 180°C for 1 hour under an atmosphere in which an oxygen concentration and a moisture concentration were each controlled at not more than 10 ppm as expressed by a volumetric ratio, to obtain a hole transporting layer.

Then, a polymer compound 2 which is a white light emitting material was dissolved in xylene to produce a xylene solution 2. A concentration of the polymer compound 2 in the xylene solution 2 was made to be 1.3% by weight. Then, under a nitrogen atmosphere in which an oxygen concentration and a moisture concentration were each controlled at not more than 10 ppm as expressed by a volumetric ratio, the xylene solution 2 was applied to the hole transporting layer by a spin coating method to form a thin film for a light emitting layer having a film thickness of 65 nm, and the thin film was stored in the dark place (illumination: 0 lux, measured using HIOKI lux HI TESTER 3421 (Tradename, available from Hioki E.E. CORPORATION, illuminometer) for 20 minutes under an atmospheric environment to obtain an organic film. In addition, the organic film was baked by heating at 130°C for 10 minutes under an atmosphere in which the oxygen concentration and the moisture concentration were each controlled at not more than 10 ppm as expressed by a volumetric ratio to obtain a light emitting layer. In addition, in the steps of forming and baking the thin film, the pressure was set at the atmospheric pressure.

Then, after the pressure was reduced to not more than $1.0 \times 10^{-4}$ Pa, as a cathode, sodium fluoride was deposited at a thickness of about 4 nm and then, aluminum was deposited at a thickness of about 80 nm. After deposition, sealing was performed using a glass substrate to produce an organic EL device.

The produced organic EL device emitted white light (CIE 1931: (0.36, 0.33)) at 1,000 cd/$m^2$, and had a maximum current efficiency of 10.1 cd/A. In addition, when the device was driven at a constant current at an initial luminance of 5,000 cd/$m^2$, a time during which the luminance became 50% of the initial luminance (lifetime) was 200 hours.

(Comparative Example 1)

An organic EL device having the following constitution was produced.
"Glass substrate / ITO (150 nm) / Baytron P (65 nm) / polymer compound 1 (20 nm) / polymer compound 2 (65 nm) / NaF (4 nm) / Al (80 nm)"

A suspension of poly(3,4)ethylenedioxythiophene / polystyrene sulfonic acid (manufactured by Starck; Baytorn P) was applied to a glass substrate on which an ITO film (anode) having a thickness of 150 nm had been formed by a sputtering method, by a spin coating method to form a thin film having a thickness of 65 nm and, further, the thin film was baked by heating on a hot plate at 200°C for 10 minutes to obtain a hole injecting layer. In addition, in formation of the hole injecting layer, the steps of forming and baking the film were performed under an atmospheric environment.

Then, a polymer compound 1 which is a hole transporting material was dissolved in xylene to produce a xylene solution 1. A concentration of the polymer compound 1 in this xylene solution 1 was made to be 0.8% by weight. Then, under a nitrogen atmosphere in which an oxygen concentration and a moisture concentration were each controlled at not more than 10 ppm as expressed by a volumetric ratio, the xylene solution 1 was applied to the hole injecting layer by a spin coating method to form a thin film for a hole transporting layer having a film thickness of 20 nm, and the thin film was baked by heating at 180°C for 1 hour under an atmosphere in which an oxygen concentration and a moisture concentration were each controlled at not more than 10 ppm as expressed by a volumetric ratio, to obtain a hole transporting layer.

Then, a polymer compound 2 which is a white light emitting material was dissolved in xylene to produce a xylene solution 2. A concentration of the polymer compound 2 in the xylene solution 2 was made to be 1.3% by weight.

Then, under a nitrogen atmosphere in which an oxygen concentration and a moisture concentration were each controlled at not more than 10 ppm as expressed by a volumetric ratio, the xylene solution 2 was applied to the hole transporting layer by a spin coating method to form a thin film for a light emitting layer having a film thickness of 65 nm, and the thin film was stored in an environment of yellow light (illumination: 330 lux, measured using HIOKI lux HI TESTER 3421 (Tradename, available from Hioki E.E. CORPORATION, illuminometer) for 20 minutes under an atmospheric environment to obtain an organic film. A spectrum of yellow light measured using a miniature spectrometer (device name: USB2000+ Miniature Fiber Optic Spectrometer, manufactured by Ocean Optics Inc.) is shown in Fig. 3. In addition, the organic film was baked by heating at 130°C for 10 minutes under an atmosphere in which the oxygen concentration and the moisture concentration were each controlled at not more than 10 ppm as expressed by a volumetric ratio to obtain a light emitting layer. In addition, in the steps of forming and baking the thin film, the pressure was set at the atmospheric pressure.

Then, after the pressure was reduced to not more than $1.0 \times 10^{-4}$ Pa, as a cathode, sodium fluoride was deposited at a thickness of about 4 nm and then, aluminum was deposited at a thickness of about 80 nm. After deposition, sealing was performed using a glass substrate to produce an organic EL device.

The produced organic EL device emitted white light (CIE 1931: (0.36, 0.33)) at 1,000 cd/$m^2$, and had a maximum current efficiency of 7.5 cd/A. In addition, when the device was driven at a constant current at an initial luminance of 5,000 cd/$m^2$, a time during which the luminance became 50% of the initial luminance (lifetime) was 98 hours.

(Comparative Example 2)

An organic EL device having the following constitution was produced.
"Glass substrate / ITO (150 nm) / Baytron P (65 nm) / polymer compound 1 (20 nm) / polymer compound 2 (65 nm) / NaF (4 nm) / Al (80 nm)"

A suspension of poly(3,4)ethylenedioxythiophene / polystyrene sulfonic acid (manufactured by Starck; Baytorn P) was applied to a glass substrate on which an ITO film (anode) having a thickness of 150 nm had been formed by a sputtering method, by a spin coating method to form a thin film having a thickness of 65 nm and, further, the thin film was baked by heating on a hot plate at 200°C for 10 minutes to obtain a hole injecting layer. In addition, in formation of the hole injecting layer, the steps of forming and baking the film were performed under an atmospheric environment.

Then, a polymer compound 1 which is a hole transporting material was dissolved in xylene to produce a xylene solution 1. A concentration of the polymer compound 1 in this xylene solution 1 was made to be 0.8% by weight. Then, under a nitrogen atmosphere in which an oxygen concentration and a moisture concentration were each controlled at not more than 10 ppm as expressed by a volumetric ratio, the xylene solution 1 was applied to the hole injecting layer by a spin coating method to form a thin film for a hole transporting layer having a film thickness of 20 nm, and the thin film was baked by heating at 180°C for 1 hour under an atmosphere in which an oxygen concentration and a moisture concentration were each controlled at not more than 10 ppm as expressed by a volumetric ratio, to obtain a hole transporting layer.

Then, a polymer compound 2 which is a white light emitting material was dissolved in xylene to produce a xylene solution 2. A concentration of the polymer compound 2 in the xylene solution 2 was made to be 1.3% by weight. Then, under a nitrogen atmosphere in which an oxygen concentration and a moisture concentration were each controlled at not more than 10 ppm as expressed by a volumetric ratio, the xylene solution 2 was applied to the hole transporting layer by a spin coating method to form a thin film for a light emitting layer having a film thickness of 65 nm, and the thin film was stored in an environment of red light (illumination: 200 lux, measured using HIOKI lux HI TESTER 3421 (Tradename, available from Hioki E.E. CORPORATION, illuminometer) for 20 minutes under an atmospheric environment to obtain an organic film. A spectrum of red light measured using a small spectrometer (device name: small multichannel spectrometer USB2000+, manufactured by Ocean Optics Inc.) is shown in Fig. 4. In addition, the organic film was baked by heating at 130°C for 10 minutes under an atmosphere in which the oxygen concentration and the moisture concentration were each controlled at not more than 10 ppm as expressed by a volumetric ratio to obtain a light emitting layer. In addition, in the steps of forming and baking the thin film, the pressure was set at the atmospheric pressure.

Then, after the pressure was reduced to not more than $1.0 \times 10^{-4}$ Pa, as a cathode, sodium fluoride was deposited at a thickness of about 4 nm and then, aluminum was deposited at a thickness of about 80 nm. After deposition, sealing was performed using a glass substrate to produce an organic EL device.

The produced organic EL device emitted white light (CIE 1931: (0.36, 0.33)) at 1,000 cd/$m^2$, and had a maximum current efficiency of 7.4 cd/A. In addition, when the device was driven at a constant current at an initial luminance of 5,000 cd/$m^2$, a time during which the luminance became 50% of the initial luminance (lifetime) was 92 hours.

(Example 2)

An organic EL device having the following constitution was manufactured.
"Glass substrate /ITO (150 nm) / Baytron P (65 nm) / polymer compound 1 (20 nm) / polymer compound 3 (60 nm) /

NaF (4 nm) / Al (80 nm)"

A suspension of poly(3,4)ethylenedioxythiophene / polystyrene sulfonic acid (manufactured by Starch Baytorn P) was applied to a glass substrate on which an ITO film (anode) having a thickness of 150 nm had been formed by a sputtering method, by a spin coating method to form a thin film having a thickness of 65 nm and, further, the thin film was baked by heating on a hot plate at 200°C for 10 minutes to obtain a hole injecting layer. In addition, in formation of the hole injecting layer, the steps of forming and baking the film were performed under an atmospheric environment.

Then, a polymer compound 1 which is a hole transporting material was dissolved in xylene to prepare a xylene solution 1. A concentration of the polymer compound 1 in this xylene solution 1 was made to be 0.8% by weight. Then, under a nitrogen atmosphere in which an oxygen concentration and a moisture concentration were each controlled at not more than 10 ppm as expressed by a volumetric ratio, the xylene solution 1 was applied to the hole injecting layer by a spin coating method to form a thin film for a hole transporting layer having a film thickness of 20 nm, and the thin film was baked by heating at 180°C for 1 hour under an atmosphere in which an oxygen concentration and a moisture concentration were each controlled at not more than 10 ppm as expressed by a volumetric ratio, to obtain a hole transporting layer.

Then, a polymer compound 3 which is a blue light emitting material was dissolved in xylene to produce a xylene solution 3. A concentration of the polymer compound 3 in the xylene solution 3 was made to be 1.3% by weight. Then, under a nitrogen atmosphere in which an oxygen concentration and a moisture concentration were each controlled at not more than 10 ppm as expressed by a volumetric ratio, the xylene solution 3 was applied to the hole transporting layer by a spin coating method to form a thin film for a light emitting layer having a film thickness of 60 nm, and the thin film was stored in the dark place (illumination: 0 lux, measured using HIOKI lux HI TESTER 3421 (Tradename, available from Hioki E.E. CORPORATION, illuminometer) for 20 minutes under an atmospheric environment to obtain an organic film. In addition, the organic film was baked by heating at 130°C for 10 minutes under an atmosphere in which the oxygen concentration and the moisture concentration were each controlled at not more than 10 ppm as expressed by a volumetric ratio to obtain a light emitting layer. In addition, in the steps of forming and baking the thin film, the pressure was set at the atmospheric pressure.

Then, after the pressure was reduced to not more than $1.0 \times 10^{-4}$ Pa, as a cathode, sodium fluoride was deposited at a thickness of about 4 nm and then, aluminum was deposited at a thickness of about 80 nm. After deposition, sealing was performed using a glass substrate to produce an organic EL device.

The produced organic EL device emitted blue light (CIE 1931: (0.17, 0.27)) at 1,000 cd/$m^2$, and had a maximum current efficiency of 7.1 cd/A. In addition, when the device was driven at a constant current at an initial luminance of 5,000 cd/$m^2$, a time during which the luminance became 50% of the initial luminance (lifetime) was 60 hours.

(Comparative Example 3)

An organic EL device having the following constitution was produced.
"Glass substrate / ITO (150 nm) / Baytron P (65 nm) / polymer compound 1 (20 nm) / polymer compound 3 (60 nm) / NaF (4 nm) / Al (80 nm)"

A suspension of poly(3,4)ethylenedioxythiophene / polystyrene sulfonic acid (manufactured by Starch Baytorn P) was applied to a glass substrate on which an ITO film (anode) having a thickness of 150 nm had been formed by a sputtering method, by a spin coating method to form a thin film having a thickness of 65 nm and, further, the thin film was baked by heating on a hot plate at 200°C for 10 minutes to obtain a hole injecting layer. In addition, in formation of the hole injecting layer, the steps of forming and baking the film were performed under an atmospheric environment.

Then, a polymer compound 1 which is a hole transporting material was dissolved in xylene to prepare a xylene solution 1. A concentration of the polymer compound 1 in this xylene solution 1 was made to be 0.8% by weight. Then, under a nitrogen atmosphere in which an oxygen concentration and a moisture concentration were each controlled at not more than 10 ppm as expressed by a volumetric ratio, the xylene solution 1 was applied to the hole injecting layer by a spin coating method to form a thin film for a hole transporting layer having a film thickness of 20 nm, and the thin film was baked by heating at 180°C for 1 hour under an atmosphere in which an oxygen concentration and a moisture concentration were each controlled at not more than 10 ppm as expressed by a volumetric ratio, to obtain a hole transporting layer.

Then, a polymer compound 3 which is a blue light emitting material was dissolved in xylene to produce a xylene solution 3. A concentration of the polymer compound 3 in the xylene solution 3 was made to be 1.3% by weight. Then, under a nitrogen atmosphere in which an oxygen concentration and a moisture concentration were each controlled at not more than 10 ppm as expressed by a volumetric ratio, the xylene solution 3 was applied to the hole transporting layer by a spin coating method to form a thin film for a light emitting layer having a film thickness of 60 nm, and the thin film was stored in an environment of yellow light (illumination: 330 lux, measured using HIOKI lux HI TESTER 3421 (Tradename, available from Hioki E.E. CORPORATION, illuminometer) for 20 minutes under an atmospheric environment to obtain an organic film. A spectrum of yellow light measured using a small spectrometer (device name: small multichannel

spectrometer USB2000+, manufactured by Ocean Optics) is shown in Fig. 3. In addition, the organic film was baked by heating at 130°C for 10 minutes under an atmosphere in which the oxygen concentration and the moisture concentration were each controlled at not more than 10 ppm as expressed by a volumetric ratio to obtain a light emitting layer. In addition, in the steps of forming and baking the thin film, the pressure was set at the atmospheric pressure.

Then, after the pressure was reduced to not more than $1.0 \times 10^{-4}$ Pa, as a cathode, sodium fluoride was deposited at a thickness of about 4 nm and then, aluminum was deposited at a thickness of about 80 nm. After deposition, sealing was performed using a glass substrate to produce an organic EL device.

The produced organic EL device emitted blue light (CIE 1931: (0:16, 0.23)) at 1,000 cd/m$^2$, and had a maximum current efficiency of 6.4 cd/A. In addition, when the device was driven at a constant current at an initial luminance of 5,000 cd/m$^2$, a time during which the luminance became 50% of the initial luminance (lifetime) was 37 hours.

(Example 3)

An organic EL device having the following constitution was produced.
"Glass substrate / ITO (150 nm) / Baytron P (65 nm) / polymer compound 4 (20 nm) / polymer compound 5 (60 nm) / Ba (5 nm) / Al (80 nm)"

A suspension of poly(3,4)ethylenedioxythiophene / polystyrene sulfonic acid (manufactured by Starck; Baytorn P) was applied to a glass substrate on which an ITO film (anode) having a thickness of 150 nm had been formed by a sputtering method, by a spin coating method to form a thin film having a thickness of 65 nm and, further, the thin film was baked by heating on a hot plate at 200°C for 10 minutes to obtain a hole injecting layer. In addition, in formation of the hole injecting layer, the steps of forming and baking the film were performed under an atmospheric environment.

Then, a polymer compound 4 which is a hole transporting material was dissolved in xylene to prepare a xylene solution 4. A concentration of the polymer compound 4 in this xylene solution 4 was made to be 0.8% by weight. Then, under a nitrogen atmosphere in which an oxygen concentration and a moisture concentration were each controlled at not more than 10 ppm as expressed by a volumetric ratio, the xylene solution 4 was applied to the hole injecting layer by a spin coating method to form a thin film for a hole transporting layer having a film thickness of 20 nm, and the thin film was baked by heating at 180°C for 1 hour under an atmosphere in which an oxygen concentration and a moisture concentration were each controlled at not more than 10 ppm as expressed by a volumetric ratio, to obtain a hole transporting layer.

Then, a polymer compound 5 which is a blue light emitting material was dissolved in xylene to produce a xylene solution 5. A concentration of the polymer compound 5 in the xylene solution 5 was made to be 1.3% by weight. Then, under a nitrogen atmosphere in which an oxygen concentration and a moisture concentration were each controlled at not more than 10 ppm as expressed by a volumetric ratio, the xylene solution 5 was applied to the hole transporting layer by a spin coating method to form a thin film for a light emitting layer having a film thickness of 60 nm, and the thin film was stored in the dark place (illumination 0 lux, measured using HIOKI lux HI TESTER 3421 (Tradename, available from Hioki E.E. CORPORATION, illuminometer) for 20 minutes under an atmospheric environment to obtain an organic film. In addition, the organic film was baked by storing at 130°C for 60 minutes in a vacuum of $5.0 \times 10^{-4}$Pa or less to obtain a light emitting layer. In addition, in the steps of forming and baking the hole transporting layer and of forming the light emitting layer, the pressure was set at the atmospheric pressure.

Then, after the pressure was reduced to not more than $1.0 \times 10^{-4}$ Pa, as a cathode, barium was deposited at a thickness of about 5 nm and, then, aluminum was deposited at a thickness of about 80 nm. After deposition, sealing was performed using a glass substrate to produce an organic EL device.

The produced organic EL device emitted blue light (CIE 1931: (0.15, 0.16)) at 1,000 cd/m$^2$, and had a maximum current efficiency of 5.7 cd/A. In addition, when the device was driven at a constant current at an initial luminance of 5,000 cd/m$^2$, a time during which the luminance became 50% of the initial luminance (lifetime) was 82 hours.

(Comparative Example 4)

An organic EL device having the following constitution was produced.
"Glass substrate / ITO (150 nm) / Baytron P (65 nm) / polymer compound 4 (20 nm) / polymer compound 5 (60 nm) / Ba (5 nm) / Al (80 nm)"

A suspension of poly(3,4)ethylenedioxythiophene / polystyrene sulfonic acid (manufactured by Starck; Baytorn P) was applied to a glass substrate on which an ITO film (anode) having a thickness of 150 nm had been formed by a sputtering method, by a spin coating method to form a thin film having a thickness of 65 nm and, further, the thin film was baked by heating on a hot plate at 200°C for 10 minutes to obtain a hole injecting layer. In addition, in formation of the hole injecting layer, the steps of forming and baking the film were performed under an atmospheric environment.

Then, a polymer compound 4 which is a hole transporting material was dissolved in xylene to prepare a xylene solution 4. A concentration of the polymer compound 4 in this xylene solution 4 was made to be 0.8% by weight. Then,

under a nitrogen atmosphere in which an oxygen concentration and a moisture concentration were each controlled at not more than 10 ppm as expressed by a volumetric ratio, the xylene solution 4 was applied to the hole injecting layer by a spin coating method to form a thin film for a hole transporting layer having a film thickness of 20 nm, and the thin film was baked by heating at 180°C for 1 hour under an atmosphere in which an oxygen concentration and a moisture concentration were each controlled at not more than 10 ppm as expressed by a volumetric ratio, to obtain a hole transporting layer.

Then, a polymer compound 5 which is a blue light emitting material was dissolved in xylene to produce a xylene solution 5. A concentration of the polymer compound 5 in the xylene solution 5 was made to be 1.3% by weight. Then, under a nitrogen atmosphere in which an oxygen concentration and a moisture concentration were each controlled at not more than 10 ppm as expressed by a volumetric ratio, the xylene solution 5 was applied to the hole transporting layer by a spin coating method to form a thin film for a light emitting layer having a film thickness of 60 nm, and the thin film was stored in an environment of yellow light (illumination 330 lux, measured using HIOKI lux HI TESTER 3421 (Tradename, available from Hioki E.E. CORPORATION, illuminometer) for 20 minutes under an atmospheric environment to obtain an organic film. A spectrum of yellow light measured using a small spectrometer (device name: small multichannel spectrometer USB2000+, manufactured by Ocean Optics Inc.) is shown in Fig. 3. In addition, the organic film was baked by storing at 130°C for 60 minutes in a vacuum of $5.0 \times 10^{-4}$Pa or less to obtain a light emitting layer. In addition, in the steps of forming and baking the hole transporting layer and of forming the light emitting layer, the pressure was set at the atmospheric pressure.

Then, after the pressure was reduced to not more than $1.0 \times 10^{-4}$Pa, as a cathode, barium was deposited at a thickness of about 5 nm and, then, aluminum was deposited at a thickness of about 80 nm. After deposition, sealing was performed using a glass substrate to produce an organic EL device.

The produced organic EL device emitted blue light (CIE 1931: (0.15, 0.16)) at 1,000 cd/$m^2$, and had a maximum current efficiency of 5.6 cd/A. In addition, when the device was driven at a constant current at an initial luminance of 5,000 cd/$m^2$, a time during which the luminance became 50% of the initial luminance (lifetime) was 73 hours.

Even when organic EL devices are produced in the manners similar to those in Examples 1, 2 and 3 using, for example, a polymer compound 6 instead of the above-mentioned polymer compound 1 or 4, and using Lumation BP361 (manufactured by Sumation Co., Ltd.) instead of polymer compound 2, 3 or 5, organic EL devices each having long lifetime similar to the organic EL devices of Examples 1, 2 and 3 can be produced.

(polymer compound 6)

A polymer compound 6 comprising two repeating units each represented by formulae shown below was synthesized in the following manner.

[Chemical Formula 1]

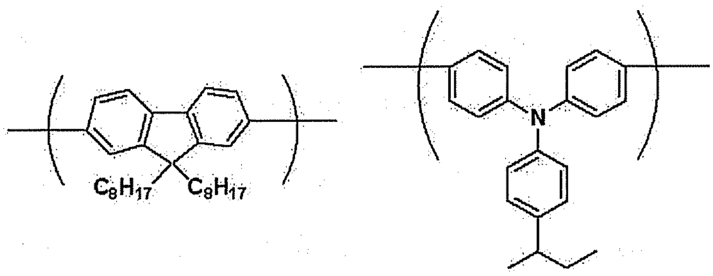

Under an inert atmosphere,

2,7-bis(1,3,2-dioxaboran-2-yl)-9,9-dioctylfluorene (5.20 g), bis(4-bromophenyl)-(4-secondarybutylphenyl)-amine (5.42 g), palladium acetate (2.2 mg), tri(2-methylphenyl)phosphine (15.1 mg), Aliquat 336 (registered trademark) (0.91 g, manufactured by Aldrich), and toluene (70 ml) were mixed, and the mixture was heated to 105°C. A 2M aqueous $Na_2CO_3$ solution (19 ml) was added dropwise to this reaction solution, followed by refluxing for 4 hours. After the reaction, phenylboric acid (121 mg) was added, followed by further refluxing for 3 hours. Then, an aqueous sodium diethyldithiacarbamate solution was added, followed by stirring at 80°C for 4 hours. After cooling, the reactant was washed with water (60 ml) three times, a 3% by weight aqueous acetic acid solution (60 ml) three times, and water (60 ml) three times, and was purified by passing through an alumina column and a silica gel column. The resulting toluene solution was added dropwise to methanol (3 L), the mixture was stirred for 3 hours, and the resulting solid was filtered, and dried. The yield of the obtained polymer compound 6 was 5.25 g.

The polystyrene-equivalent number average molecular weight of the polymer compound 6 was $1.2\times10^5$, and the polystyrene-equivalent weight average molecular weight thereof was $2.6\times10^5$.

(Example 4 and Comparative Example 5)

According to the same manner as in Example 1 except that a white light emitting high-molecular material "White 1330" manufactured by Sumation Co., Ltd. is used instead of the polymer compound 2, an organic EL device is produced (Example 4). In addition, after forming the film for the light emitting layer, according to the same manner as in Example 4 except that the film is stored in an environment of yellow light (illumination: 330 lux) or of red light (illumination: 200 lux) instead of being stored in the dark place, an organic EL device is produced (Comparative Example 5). Both produced organic EL devices emit white light. When the properties of those organic EL devices are measured in the same manner as in Example 1, a significant improvement in at least the maximum current efficiency or the luminance half life is observed in the organic EL device in Example 4 compared with the organic EL device in Comparative Example 5.

(Example 5 and Comparative Example 6)

According to the same manner as in Example 2 except that a blue light emitting high-molecular material "Lumation BP361" manufactured by Sumation Co., Ltd. is used instead of the polymer compound 3, an organic EL device is produced (Example 5). In addition, after forming the film for the light emitting layer, according to the same manner as in Example 5 except that the film is stored in an environment of yellow light (illumination: 330 lux) or of red light (illumination: 200 lux) instead of being stored in the dark place, an organic EL device is produced (Comparative Example 6). Both produced organic EL devices emit blue light. When the properties of those organic EL devices are measured in the same manner as in Example 2, a significant improvement in at least the maximum current efficiency or the luminance half life is observed in the organic EL device in Example 5 compared with the organic EL device in Comparative Example 6.

DESCRIPTION OF REFERENCE NUMERALS

1... Organic EL device,
2... Substrate,
3... First electrode,
4... Hole injecting layer,
5... Hole transporting layer,
6... Light emitting layer,
7... Second electrode,
10... Applying means,
11... Nozzle,
19... Tank,
20... Conduit.

## Claims

1. A method for producing an organic electroluminescent device comprising a first electrode, a second electrode and a light emitting layer arranged between the first and second electrodes, the light emitting layer containing an organic film, the method comprising a step of applying a solution containing an organic compound onto the surface of a layer which is to be located just below the light emitting layer, to form the organic film in a dark place.

2. The method for producing an organic electroluminescent device according to claim 1, wherein the first electrode is an anode.

3. The method for producing an organic electroluminescent device according to claim 1, wherein the organic film is formed under an atmosphere containing an inert gas.

4. The method for producing an organic electroluminescent device according to any of claims 1 to 3, wherein the organic film is formed under an atmosphere which has an oxygen concentration of not more than 10 ppm by volume and/or a moisture concentration of not more than 10 ppm by volume.

**5.** The method for producing an organic electroluminescent device according to any of claims 1 to 3, wherein the organic film is formed under an atmospheric environment.

**6.** The method for producing an organic electroluminescent device according to any of claims 1 to 5, wherein the method further comprises a step of baking the organic film.

**7.** The method for producing an organic electroluminescent device according to claim 6, wherein the organic film is baked under an atmosphere which contains an inert gas.

**8.** The method for producing an organic electroluminescent device according to claim 6 or 7, wherein the organic film is baked under a reduced pressure not more than 10 Pa.

**9.** The method for producing an organic electroluminescent device according to any of claims 1 to 8, wherein the organic electroluminescent device comprises a functional layer which is in contact with the light emitting layer.

**10.** The method for producing an organic electroluminescent device according to claim 9, wherein the functional layer is located between the light emitting layer and the first electrode.

**11.** The method for producing an organic electroluminescent device according to claim 9 or 10, wherein the functional layer comprises a polymer compound.

**12.** The method for producing an organic electroluminescent device according to any of claims 1 to 11, wherein the organic compound is a polymer compound.

**13.** The method for producing an organic electroluminescent device according to any of claims 1 to 12, wherein the solution containing an organic compound is a solution which has been stored in a dark place.

**14.** The method for producing an organic electroluminescent device according to any of claims 1 to 13, wherein the solution containing an organic compound is a solution which has been prepared by dissolving the organic compound into a solvent in a dark place.

**15.** An organic electroluminescent device produced by the method for producing an organic electroluminescent device according to any of claims 1 to 14.

**16.** A planar light source comprising the organic electroluminescent device according to claim 15.

**17.** A display apparatus comprising the organic electroluminescent device according to claim 15.

**18.** An illumination apparatus comprising the organic electroluminescent device according to claim 15.

**19.** An apparatus for producing an organic electroluminescent device comprising a first electrode, a second electrode and a light emitting layer arranged between the first and second electrodes, the light emitting layer containing an organic film, wherein the apparatus comprises a tank for storing a solution containing an organic compound; a conduit through which the solution is fed from within the tank to outside the tank; and an applying means that receives the solution containing the organic compound from the conduit and applies the solution containing the organic compound onto the surface of a layer which is to be located just below the light emitting layer, to form the organic film in a dark place, wherein at least one of the tank and the conduit has light shielding property.

[Figure 1]

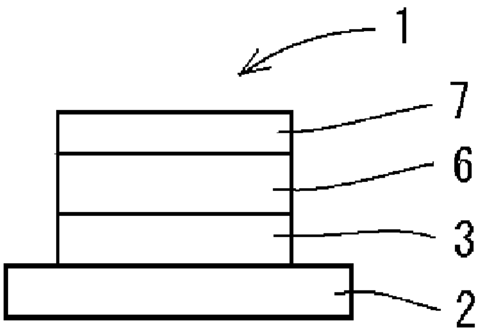


[Figure 2]

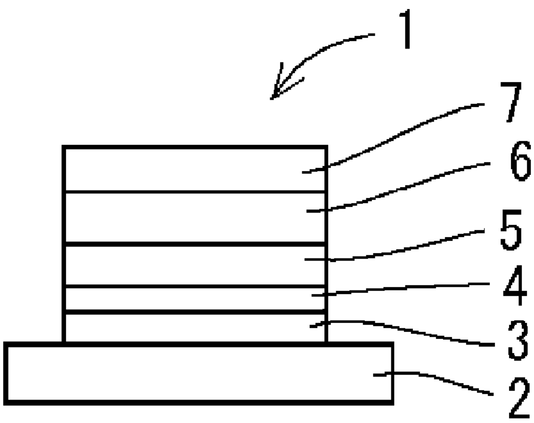

[Figure 3]

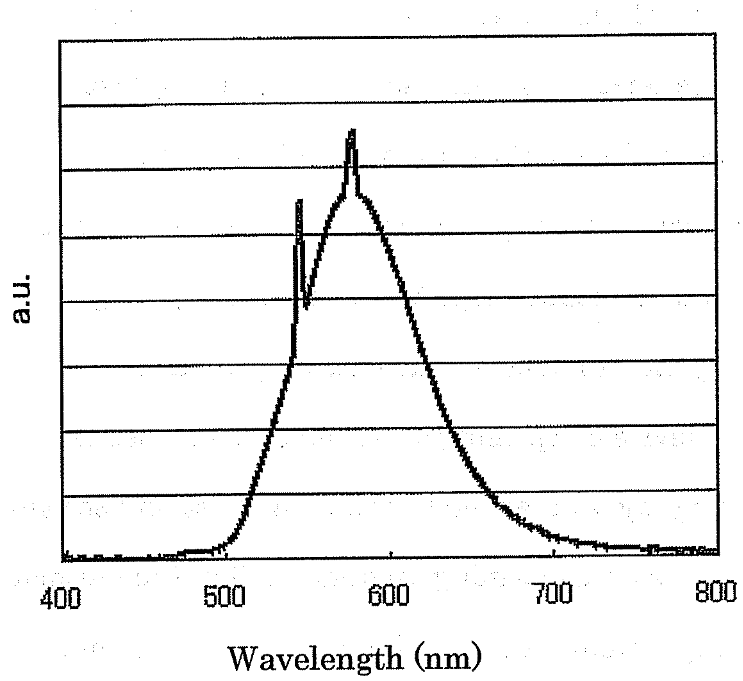


[Figure 4]

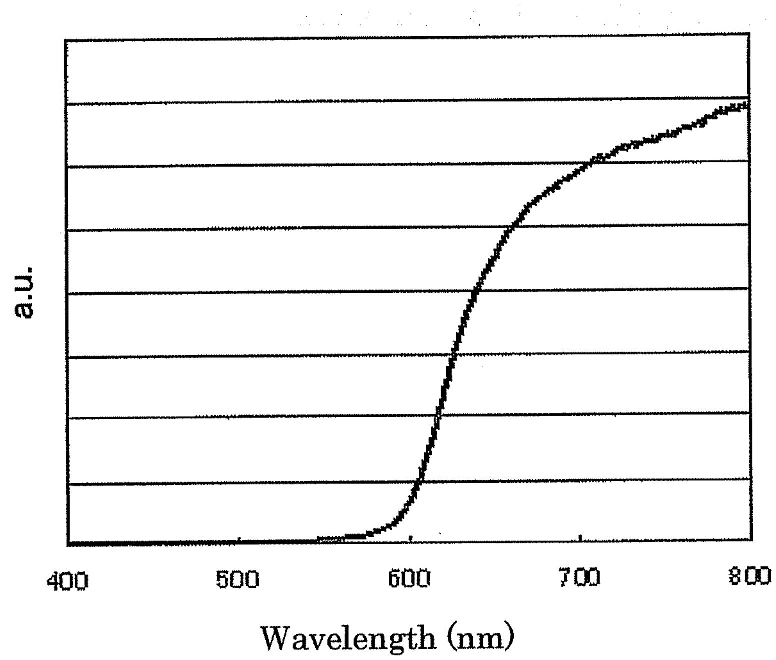

[Figure 5]

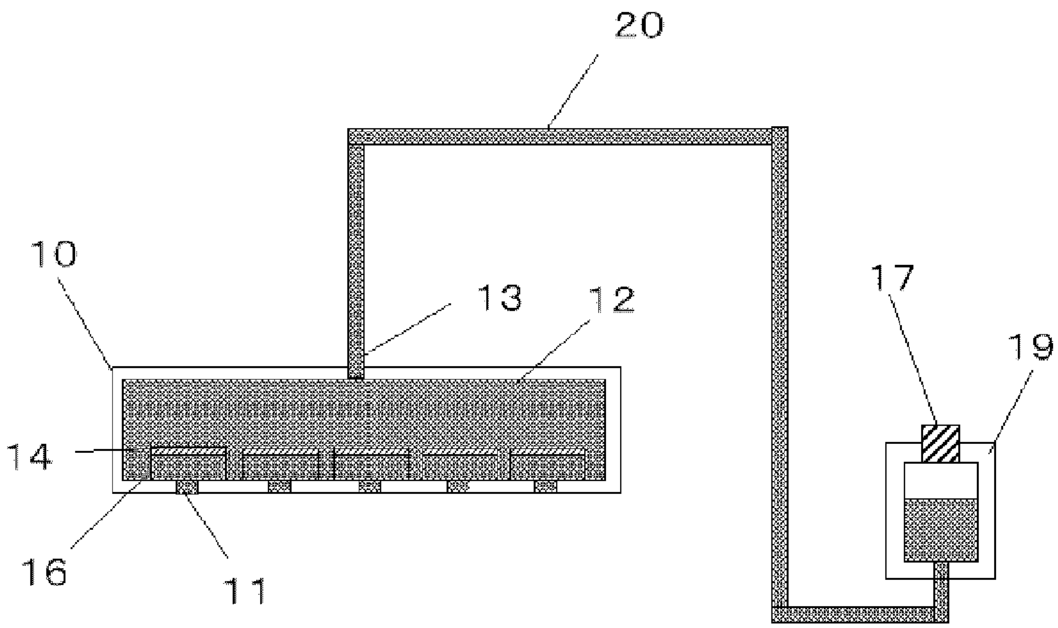

[Figure 6-a]

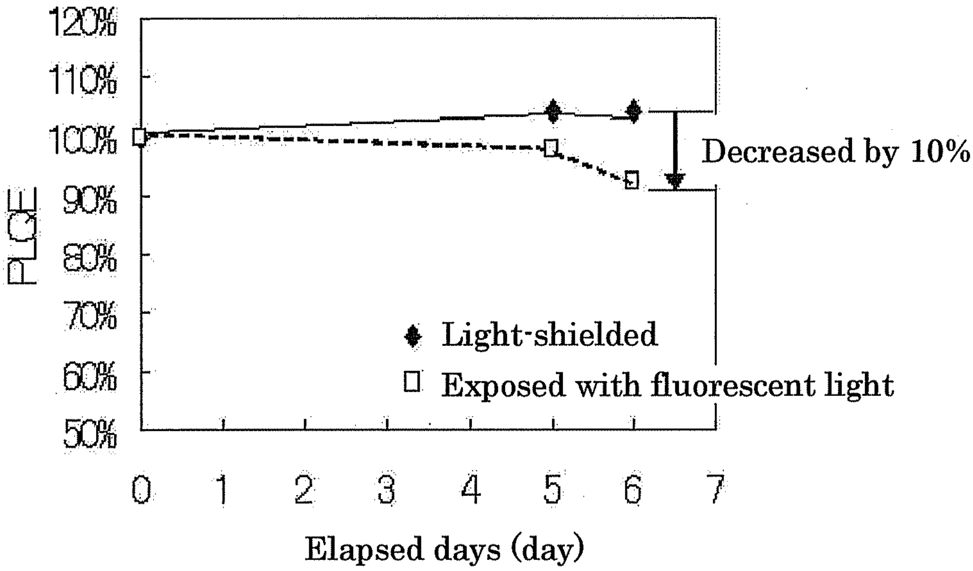


[Figure 6-b]

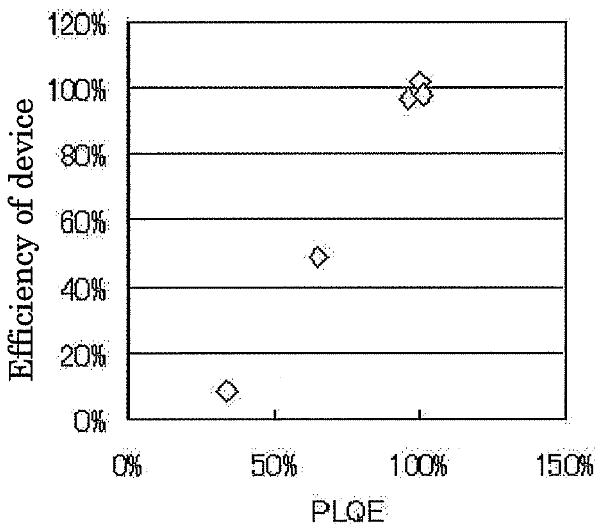

**INTERNATIONAL SEARCH REPORT**

International application No.
PCT/JP2011/052343

A. CLASSIFICATION OF SUBJECT MATTER
*H05B33/10*(2006.01)i, *H01L51/50*(2006.01)i

According to International Patent Classification (IPC) or to both national classification and IPC

B. FIELDS SEARCHED

Minimum documentation searched (classification system followed by classification symbols)
H05B33/10, H01L51/50

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2011 |
| Kokai Jitsuyo Shinan Koho | 1971-2011 | Toroku Jitsuyo Shinan Koho | 1994-2011 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br><br>Y | JP 2003-17267 A (Toppan Printing Co., Ltd.), 17 January 2003 (17.01.2003), paragraphs [0012] to [0021] (Family: none) | 1-3,5,9-12, 15-18<br>4,6-8,13,14, 19 |
| X<br><br>Y | JP 2003-59659 A (Toppan Printing Co., Ltd.), 28 February 2003 (28.02.2003), paragraphs [0016] to [0026] (Family: none) | 1-3,5,9-12, 15-18<br>4,6-8,13,14, 19 |
| Y | JP 2007-165605 A (Showa Denko Kabushiki Kaisha), 28 June 2007 (28.06.2007), claim 16; paragraphs [0051] to [0075] (Family: none) | 1-19 |

☒ Further documents are listed in the continuation of Box C.

☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| | |
|---|---|
| Date of the actual completion of the international search<br>04 April, 2011 (04.04.11) | Date of mailing of the international search report<br>10 May, 2011 (10.05.11) |
| Name and mailing address of the ISA/<br>Japanese Patent Office | Authorized officer |
| Facsimile No. | Telephone No. |

Form PCT/ISA/210 (second sheet) (July 2009)

**INTERNATIONAL SEARCH REPORT**

International application No.
PCT/JP2011/052343

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2002-170676 A (Fuji Photo Film Co., Ltd.), 14 June 2002 (14.06.2002), paragraphs [0017], [0056] (Family: none) | 4 |
| Y | JP 2004-55333 A (Fuji Photo Film Co., Ltd.), 19 February 2004 (19.02.2004), paragraphs [0028] to [0035], [0044], [0076], [0077], [0082] (Family: none) | 4 |
| Y | JP 8-306954 A (Katsumi YOSHINO, Kobe Steel, Ltd.), 22 November 1996 (22.11.1996), paragraphs [0037], [0040], [0049] (Family: none) | 6-8 |
| Y | JP 2006-144112 A (Dainippon Printing Co., Ltd.), 08 June 2006 (08.06.2006), paragraphs [0129] to [0137] & US 2006/0083655 A1 & GB 2419465 A & GB 521306 D0 | 6,7 |
| Y | JP 2009-102656 A (Mitsubishi Chemical Corp.), 14 May 2009 (14.05.2009), paragraphs [0372], [0408] & JP 2006-257409 A & US 2009/0066223 A1 & EP 1857521 A1 & WO 2006/095539 A1 & KR 10-2007-0110498 A & CN 101128560 A | 13,19 |
| Y | JP 2006-16394 A (Samsung SDI Co., Ltd.), 19 January 2006 (19.01.2006), paragraph [0066] & US 2005/0287391 A1 & KR 10-2006-0000776 A & CN 1715363 A | 14,19 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2004055333 A
- JP 2007165605 A